# EUROPÄISCHE PATENTANMELDUNG

(11) **EP 4 807 773 A1**
(43) Veröffentlichungstag der Anmeldung: **16.09.2026**
(21) Anmeldenummer: 26156840.6
(22) Anmeldetag: 06.02.2026
(51) Int. Cl.: H01H 1/40, H01H 1/027, H01H 1/26, H01H 15/00, H01H 15/02, H01H 15/08, H01H 9/06, H01H 1/36, H01H 25/00, H05K 1/11

(54) **ELEKTRISCHER SCHALTER SOWIE LEITERPLATTE**

(30) Priorität: 13.03.2025 DE 102025109682
(71) Anmelder: Metabowerke GmbH, 72622 Nürtingen (DE)
(72) Erfinder: Spuhler, Edwin, 72622 Nürtingen (DE); Eberhard, Peter, 73776 Altbach (DE); Getschmann, Benedikt, 72667 Schlaitdorf (DE)
(74) Vertreter: Lorenz & Kollegen

(57) **Zusammenfassung**

Die Erfindung betrifft eine angetriebene Werkzeugmaschine (100 mit einer Antriebseinheit (114) und einem elektrischen Schalter zur Anpassung einer Stellgröße der Antriebseinheit (114), beispielsweise zur Einstellung einer Drehzahl der Antriebseinheit (114), aufweisend: eine Leiterplatte (10) mit wenigstens einem Kontaktbereich (12), wenigstens ein Betätigungselement (130) zur manuellen Betätigung durch einen Anwender, und einen mit dem Betätigungselement (130) verbundenen Schleifkontakt, der wenigstens einen Gegenkontaktbereich aufweist, welcher dazu ausgebildet ist, infolge einer manuellen Betätigung des Betätigungselements (130) durch den Anwender in schleifendem Kontakt über den Kontaktbereich (12) der Leiterplatte (10) bewegt zu werden. Der Schleifkontakt ist wenigstens im Gegenkontaktbereich zur Kontaktierung des Kontaktbereichs (12) wenigstens abschnittsweise aus einem metallischen Werkstoff ausgebildet. Der Kontaktbereich (12) weist wenigstens zwei Kontaktsegmente (14, 16, 18) auf, die beabstandet zueinander an oder auf der Leiterplatte (10) angeordnet sind und jeweils eine Kontaktfläche mit einem metallischen Werkstoff aufweisen, wobei die Leiterplatte (10) in wenigstens einem zu dem Kontaktbereich (12) benachbarten Bereich wenigstens eine Leitfläche (20) zur elektrischen Verbindung der wenigstens zwei Kontaktsegmente (14, 16, 18) miteinander aufweist, und wobei die wenigstens eine Leitfläche (20) einen karbonhaltigen Werkstoff umfasst.

## Beschreibung

Die Erfindung betrifft einen elektrischen Schalter, insbesondere Betätigungsschalter, einer angetriebenen Werkzeugmaschine, beispielsweise einer Bohrmaschine, eine Leiterplatte für einen solchen elektrischen Schalter sowie ein neues Herstellungsverfahren für eine Leiterplatte für einen elektrischen Schalter einer angetriebenen Werkzeugmaschine.

Bei aus dem Stand der Technik bekannten Schaltern wird bei einem Schaltvorgang üblicherweise eine Kontaktfeder durch Betätigung eines Schaltelements, beispielsweise ein Drehknopf oder eine Taste, gegen einen Gegenkontakt gedrückt oder es sind Schleifkontakte vorgesehen. Um über Jahre hinweg ein zuverlässiges und ausfallsicheres Schalten zu gewährleisten, müssen die üblicherweise als Federkontakte ausgebildeten Kontakte und die Gegenkontakte verschleißarm ausgebildet sein. Gegenwärtig besteht eine bekannte Lösung darin, sowohl die Kontakte als auch die Gegenkontakte beispielsweise durch eine Gold- oder Silberbeschichtung zu "veredeln". Aufgrund der hohen Materialpreise ist ein Versilbern oder ein Vergolden der Kontakte/Gegenkontakte derzeit jedoch vergleichsweise teuer.

In der Druckschrift DE 100 37 155 B4 ist ein elektrischer Schalter mit einen Betätigungshebel beschrieben, der auf zwei Ansteuerhebel wirkt, die jeweils einen elektrischen Kontaktbereich besitzen, der zum Beispiel aus einer Karbonpille oder einem elastischen metallischen Bereich gebildet ist. Die Kontaktbereiche drücken bei einer Betätigung des Betätigungshebels auf eine Leiterplatte.

Die Druckschrift DE 100 26 352 A1 offenbart eine elektrische Schalteinrichtung, die einen Taster aufweist, der auf einen aufstehenden Schaltbereich einer elastischen Schaltmatte gedrückt werden kann. An der Innenseite dieses Schaltbereichs ist eine Kontaktbrücke vorgesehen, die bei einer Tasterbetätigung zwei Gegenkontakte auf der Leiterplatte elektrisch überbrückt. Für die Kontaktbrücke werden die Materialien Metall und Karbon genutzt.

Eine andere Lösung, um einen Schalter mit einfachem Aufbau bei gleichzeitig hoher Verschleißfestigkeit bereitzustellen, ist in der DE 10 2005 014 934 B3 offenbart, die auch in den Figuren 1 und 2 gezeigt ist.

Der dort offenbarte elektrische Schalter weist zumindest eine Kontaktfeder mit wenigstens einer elastischen Federzunge auf, ein auf die zumindest eine Kontaktfeder einwirkendes Schaltelement, und wenigstens einen der wenigstens einen Federzunge zugeordneten Gegenkontakt auf einer Leiterplatte. Die zumindest eine Kontaktfeder ist mit der wenigstens einen Federzunge einstückig aus Edelstahl gebildet, und der wenigstens eine Gegenkontakt auf der Leiterplatte ist aus einer Karbonschicht gebildet.

Bei diesem Schalter wird also das bisher aufwändige Vorgehen, nämlich die Veredelung eines Gegenkontakts durch Versilbern oder Vergolden, dadurch ersetzt, dass auf einer Leiterplatte ein Gegenkontakt aus einer Karbonschicht aufgebracht ist. Ein entscheidender Vorteil der Verwendung der auf der Leiterplatte aufgebrachten Karbonschicht ist zum einen in der derzeit vorliegenden Kostenersparnis im Vergleich zum Versilbern oder Vergolden bei einem herkömmlichen Gegenkontakt zu sehen. Zum anderen weist die Karbonschicht eine sehr hohe mechanische Widerstandsfähigkeit auf, sodass die Funktionsfähigkeit des Schalters auch über eine lange Zeit gewährleistet ist.

Zwar hat die Karbonschicht eine geringere Leitfähigkeit als beispielsweise eine Gold- oder Silberschicht, bei Schaltvorgängen der Lösung gemäß DE 10 2005 014 934 B3 muss jedoch lediglich ein "quasi-digitales" Schaftsignal (an/aus) ausgewertet werden und nicht etwa eine Signalintensität. Insofern ist die geringere Leitfähigkeit für einen Schalter, mit dem zwischen unterschiedlichen Schaltzuständen gewechselt wird (ein/aus), von untergeordneter Bedeutung.

Die Kontaktfeder mit der Federzunge besteht aus Edelstahl, sie ist also insbesondere unbeschichtet und nicht weiter veredelt. Weiterhin ist der Gegenkontakt auf die Leiterplatte mit einer Schichtdicke der aufgebrachten Karbonschicht etwa 5 bis 12 µm aufgedruckt. Durch das in der Leiterplattentechnologie übliche Druckverfahren ist ein einfaches Verfahren zum Aufbringen des Gegenkontakts bereitgestellt.

Gemäß einer denkbaren Lösung ist die Leiterplatte mit dem aufgebrachten Gegenkontakt zugleich eine Steuerplatine mit einem darauf integrierten Schaltungsmuster. Für die Gegenkontakte ist daher keine separate Leiterplatte vorgesehen. Vielmehr sind die Gegenkontakte unmittelbar in eine komplexe Schalt- oder Steuerplatine, die neben Leitungsbahnen auch einzelne Steuerbausteine oder Bauelemente enthalten kann, integriert. Das Schaltungsmuster besteht hierbei insbesondere aus unveredelten Leiterbahnen, beispielsweise aus Kupfer.

Bei bisherigen Lösungen wurde für die Gegenkontakte jeweils eine eigene Leiterplatte vorgesehen, bei der dann die entsprechend kurzen Leiterbahnstücke vergoldet oder versilbert wurden. Diese Leiterplatte mit den Gegenkontakten wurde dann mit einer Steuerplatine elektrisch leitend beispielsweise durch Löten einer Verbindungsleitung oder eine Steckkontaktes für eine Verbindungsleitung oder dergleichen verbunden. Dieses an sich etwas aufwändigere Verfahren mit der getrennten Leiterplatte wurde deswegen gewählt, da ansonsten verfahrenstechnisch bedingt sämtliche Leiterbahnen der Steuerplatine veredelt hätten werden müssen.

Im Unterschied hierzu ist nunmehr durch die insbesondere drucktechnische Aufbringung der Karbonschicht ein leiterplatten-spezifisches Herstellungsverfahren gewählt, sodass die Karbonschicht problemlos in den Herstellungsprozess der Leiterplatte integriert ist und problemlos nur in den gewünschten Teilbereichen aufgebracht wird.

Bei der Lösung der Druckschrift DE 10 2005 014 934 B4 wird ein Schaltelement beispielsweise als Drehknopf ausgebildet, welcher an seiner Unterseite insbesondere mit Noppen versehen ist, die in Abhängigkeit der Stellung des Schaltelements eine jeweilige Kontaktfeder gegen den zugeordneten Gegenkontakt pressen. Die Kontaktfedern sind zu ihrem Freiende und den Federzungen hin gekröpft ausgebildet. Aufgrund der Abkröpfung und der federelastischen Ausbildung gleitet hierbei das Freiende mit den Federzungen etwas über die Kontaktfläche der Gegenkontakte, sodass ein elektrischer Kontakt ausgebildet wird. Die Federzungen berühren bei Betätigung mittels des Schaltelements den Gegenkontakt nicht nur, sondern werden auch auf dem Gegenkontakt unter Druck verschoben, wodurch eine gute Oberflächenkontaktierung zwischen der Kontaktfeder und dem Gegenkontakt erzielt wird.

Weiterhin ist es aus der Praxis auch bekannt, einen elektrischen Schalter, insbesondere einen Betätigungsschalter für eine Werkzeugmaschine, mit einer Leiterplatine umzusetzen, auf die Karbonflächen zur elektrischen Kontaktierung mit einer Kontaktfeder oder mit einem Schleifkontakt aufgedruckt sind. Die Karbonflächen sind auf der Rückseite der Leiterplatine mit unterschiedlichen Widerständen verbunden.

Die Werkzeugmaschine weist ein Gehäuse mit einem von außen zugänglichen Betätigungsschalter auf. Der Betätigungsschalter, an dem der Anwender mit seinem Zeigefinger angreift (um die Drehzahl durch zunehmenden Druck zu erhöhen, sogenannter "Triggerswitch"), überfährt im Inneren des Werkzeugmaschinengehäuses die Leiterplatine des Schalters beispielsweise mit einem federnden Schleifer, wodurch positionsabhängig unterschiedliche Widerstände in den hierdurch geschlossenen Stromkreis geschaltet werden.

Nachteilig an dieser bekannten Lösung ist, dass, wenngleich die Karbonflächen auch eine höhere Abriebsfestigkeit als Gold oder Silber aufweisen, die Karbonflächen dennoch empfindlich sind und durch das regelmäßige Überfahren mit dem Schleifer sowie die dabei herrschenden Schwingungen einer Werkzeugmaschine schnell abgenutzt sind. Hierdurch stellen sich für den Anwender unerwünschte Drehzahlschwankungen ein, die beispielsweise beim Bohren oder ähnlichen Anwendungsverfahren problematisch sind.

Demgegenüber besteht eine Aufgabe der vorliegenden Erfindung darin, die bestehenden Nachteile bekannter Lösungen zumindest zu verringern.

Demgemäß schlägt die Erfindung eine angetriebene Werkzeugmaschine mit den Merkmalen des Anspruchs 1 vor.

Die erfindungsgemäße Werkzeugmaschine weist eine Antriebseinheit und einen elektrischen Schalter zur Anpassung einer Stellgröße der Antriebseinheit, beispielsweise zur Einstellung einer Drehzahl der Antriebseinheit, auf. Ein solcher beispielhafter Drehzahlsteller (auch "Triggerswitch" genannt) kann per analogem Signal eine Stellgröße, wie die Drehzahl, für die Steuerelektronik der Antriebseinheit ausgeben.

Der elektrische Schalter ist in bekannter Weise mit der Antriebseinheit verbunden und weist eine Leiterplatte mit wenigstens einem Kontaktbereich (Widerstandsleiter) auf. Weiterhin umfasst der Schalter wenigstens ein Betätigungselement zur manuellen Betätigung durch einen Anwender, und einen Schleifkontakt umfassend wenigstens einen Gegenkontaktbereich.

Der Schleifkontakt ist dazu ausgebildet, infolge einer manuellen Betätigung des Betätigungselements durch den Anwender in schleifendem Kontakt über den Kontaktbereich der Leiterplatte bewegt zu werden. Weiterhin ist der Schleifkontakt wenigstens im Gegenkontaktbereich zur Kontaktierung des wenigstens einen Kontaktbereichs der Leiterplatte wenigstens abschnittsweise aus einem metallischen Werkstoff ausgebildet. Dabei kann der Schleifkontakt vollständig aus einem oder mehreren metallischen Werkstoffen, beispielsweise aus Kupfer oder Kupferlegierungen, oder aus mehreren metallischen Materialschichten, wie beispielsweise einer Nickelunterschicht und einer Kupferbeschichtung, oder nur teilweise aus einem metallischen Werkstoff, beispielsweise einem nichtmetallischen Material mit einer metallhaltigen Beschichtung im Gegenkontaktbereich (Bereich einer Gegenkontaktfläche) ausgestaltet sein, beispielsweise mit einer Gold-Hartlegierung-Beschichtung.

Der Schleifkontakt kann als Kontaktfeder mit einer oder mehrere Federzungen oder aber als starres Schleifelement ausgebildet sein und weist zumindest eine Gegenkontaktfläche aus, mit der er zur Kontaktierung des wenigstens einen Kontaktbereichs der Leiterplatte an dieser zur (schleifenden) Anlage gelangen kann. Im Falle mehrerer Federzungen, beispielsweise zweimal drei Federzungen, die sich jeweils paarweise in entgegengesetzten Richtungen erstrecken können, werden multiple Gegenkontaktflächen der Federn (2 mal 3 Gegenkontaktflächen) bereitgestellt. Die Federkontakte müssen dazu nicht hintereinander in Bewegungsrichtung des Schleifkontakts, d.h. miteinander fluchtend angeordnet sein, sondern können auch nebeneinander oder mit Versatz zueinander geführt werden, wodurch der Schleifkontakt platzsparender, bzw. kompakter wird. Das Material des Schleifers, insbesondere das Federgrundmaterial, kann alle federnden und leitenden Stoffe umfassen. Die Geometrie des Schleifkontakts, insbesondere die Federgrundgeometrie, kann auch beispielsweise auch einzelne abgerundete und federnden Drähten aufweisen (sogenannter Multi-Wire-Wiper). Die Gegenkontaktfläche(n) kann bzw. können einen abgerundeten Umriss mit einem oder mehrere Radien haben.

In bekannter Weise kann in Abhängigkeit von der Position des Schleifkontaktes relativ zu dem Kontaktbereich eine Änderung des elektrischen Widerstandes und damit eines Einstellung der Stellgröße, wie beispielsweise der Drehzahl der Antriebseinheit, erreicht werden. Zu einer Länge des Kontaktbereichs der Leiterplatte bis zu der kontaktierenden Anlage mit dem Gegenkontakt des Schleifkontakts ist ein Ausgangssignal eines entsprechenden Schalters linear proportional.

Durch die Ausgestaltung mit wenigstens einem Kontaktbereich, der zumindest abschnittsweise aus einem metallischen Werkstoff, wie beispielsweise aus Kupfer, ausgebildet ist, wird eine robuste und zugleich sehr leitfähige Gegenkontaktfläche bereitgestellt. Zugleich ergibt sich durch die Ausgestaltung der Gegenkontaktfläche aus einem metallischen Werkstoff ein erhöhter Abrieb an der Kontaktfläche. Dementsprechend hat sich in der Praxis gezeigt, dass eine in der Praxis übliche Karbonkontaktbahn (bestehend aus weicher, leitfähiger Karbonpaste mit einem hartem nicht-leitenden Epoxyharz) mit der Zeit zumindest stellenweise die weichen Karbonpartikel infolge von Reibkorrosion ausgetragen werden. An diesen Stellen verbleibt das Harz, welches zu partiellen Unterbrechungen im Stromfluss führt und sich damit beispielsweise auf die Stellgrößeneinstellung auswirkt. So kann sich bei bekannten Lösungen, bei denen die Drehzahl der Antriebseinheit gesteuert wird, ein unerwünschter Drehzahleinbruch durch die Steuerelektronik einstellen.

Erfindungsgemäß ist daher zur Überwindung dieses bekannten Problems weiter vorgesehen, dass der wenigstens eine Kontaktbereich der Leiterplatte wenigstens zwei Kontaktsegmente (Segmente des Widerstandsleiters) aufweist, die beabstandet zueinander an oder auf der Leiterplatte angeordnet sind und jeweils eine Kontaktfläche mit einem metallischen Werkstoff aufweisen.

Die Kontaktfläche kann somit ebenfalls vollständig aus einem oder mehreren metallischen Werkstoffen, beispielsweise aus Kupfer oder Kupferlegierungen, oder aus mehreren metallischen Materialschichten, wie beispielsweise einer Nickelunterschicht und einer Kupferbeschichtung, oder nur teilweise aus einem metallischen Werkstoff, beispielsweise einem nichtmetallischen Material mit einer metallhaltigen Beschichtung im Bereich der Kontaktfläche ausgestaltet sein, beispielsweise mit einer Gold-Hartlegierung-Beschichtung.

Weiterhin kann erfindungsgemäß vorgesehen sein, dass die Leiterplatte in wenigstens einem zu dem Kontaktbereich benachbarten Bereich wenigstens eine Leitfläche zur elektrischen Verbindung der wenigstens zwei Kontaktsegmente miteinander aufweist, wobei die Leitfläche einen karbonhaltigen Werkstoff umfasst.

Eine Besonderheit liegt hierbei vor allem darin, dass die Kontaktsegmente zunächst voneinander getrennt ausgebildet und beabstandet zueinander angeordnet sind. Dies entspricht einer Kaskadenlösung, wie sie auch aus dem Stand der Technik bekannt ist. Bei bekannten Lösungen dieser Art werden die einzelnen Kontaktsegmente über in einem benachbarten Bereich vorgesehene Abgriffspunkte und diese verbindende Leiterbahnen miteinander elektrisch verbunden. Das Ausgangssignal ist bei diesen Lösung kaskadiert proportional und somit gestuft.

Anders als bei den bekannten Lösungen aus dem Stand der Technik erfolgt bei der Erfindung die elektrische Verbindung der einzelnen Kontaktsegmente indes nicht über zusätzliche Abgriffspunkte, die zusätzlich miteinander verbunden werden müssen (üblicherweise wird eine solche Verbindung mit auf der Rückseite der Leiterplatte vorgesehenen Widerständen bereitgestellt), sondern über wenigstens eine Leitfläche, die einen karbonhaltigen Werkstoff umfasst.

Auf diese Weise kann eine Lösung bereitgestellt werden, die ohne externe Festwiderstände eine langlebige und kostensparende Ausgestaltung eines elektrischen Schalters ermöglicht.

Dabei kann die wenigstens eine Leitfläche eine auf die Leiterplatte aufgebrachte, insbesondere aufgedruckte, Karbonschicht umfassen. Die Leitfläche kann beispielsweise aus weicher, leitfähiger Karbonpaste mit einem hartem nicht-leitenden Epoxyharz bestehen. Anders als im Stand der Technik wird die Leitfläche nicht von dem Schleifkontakt überfahren und somit entfällt das bekannte Problem einer Reibkorrosion, wodurch stellenweise die weichen Karbonpartikel ausgetragen werden können. Zugleich stellt die Leitfläche eine besonders einfache und kostengünstige Lösung dar, um zwei oder mehr Kontaktsegmente des Kontaktbereichs elektrisch miteinander zu verbinden.

Die empfindliche karbonhaltige Leitfläche dient somit als elektrisches Widerstandsmaterial, unterliegt jedoch keinem Verschleiß mehr, wodurch die Lebensdauer gegenüber bekannten Lösungen erhöht werden kann.

Es kann wenigsten eine Leitfläche in einem einzigen benachbarten Bereich, beispielsweise auf einer Seite neben dem Kontaktbereich ausgebildet sein (einseitige Ausgestaltung einer oder mehrerer Leitflächen). Alternativ oder zusätzlich können auch mehrere Leitflächen in einem oder in mehreren benachbarten Bereichen vorgesehen sein. So können beispielsweise auf beiden Seiten neben dem Kontaktbereich eine oder mehrere Leitflächen ausgebildet sein (doppelseitige Ausgestaltung einer oder mehrerer Leitflächen).

Gemäß einer Weiterbildung der Erfindung kann wenigstens eines der wenigstens zwei Kontaktsegmente ein Einlegeteil mit einem kupferhaltigen Werkstoff umfasst und in die Leiterplatte eingelegt ist. Alternativ können einzelne oder alle Kontaktsegmente auch eine aufgedruckte Metallschicht umfassten.

Alternativ oder zusätzlich kann vorgesehen sein, dass die wenigstens zwei Kontaktsegmente und die Leitfläche auf derselben Seite (d.h. Vorderseite oder Rückseite) der (als Flachteil ausgebildeten) Leiterplatte angeordnet sind. Hierdurch wird wiederum eine Vereinfachung bei der Fertigung erreicht.

Alternativ oder zusätzlich kann vorgesehen sein, dass die Kontaktsegmente sichelförmig oder ringbogenförmig ausgebildet sind. Aus dem Stand der Technik bekannt ist eine Ausgestaltung mit mehreren - in einer Draufsicht auf die Leiterplatte betrachtet - streifenförmigen parallel angeordneten Kontaktsegmenten, die beispielsweise in einem Anstellwinkel von 45 bis 60 Winkelgrad relativ zur Bewegungsrichtung angeordnet sind.

Bei der Weiterentwicklung der Erfindung kann anstelle einer solchen bekannten Lösung auch eine Ausgestaltung der Kontaktsegmente als sichelförmig oder ringbogenförmig- in einer Draufsicht auf die Leiterplatte betrachtet - vorgesehen sein. Die Radien solcher sichelförmig oder ringbogenförmig ausgebildeter Kontaktsegmente können so ausgestaltet und angeordnet sein, dass die wenigstens eine Gegenkontaktfläche des Schleifers, insbesondere wenn diese ebenfalls abgerundete Kanten aufweist, mit einem oder mehreren gegenläufigen Radien an die Kontaktsegmente angelegt werden, um den Verschleiß weiter zu vermindern.

Alternativ oder zusätzlich kann vorgesehen sein, dass die wenigstens zwei Kontaktsegmente in einem sich wiederholenden Muster parallel zueinander an oder auf der Leiterplatte angeordnet sind.

Alternativ oder zusätzlich kann vorgesehen sein, dass wenigstens eines der wenigstens zwei Kontaktsegmente wenigstens eine Ausnehmung, insbesondere eine Vielzahl von Ausnehmungen, aufweist, die in einem sich wiederholenden Muster und/oder in einer Struktur an dem Kontaktsegment angeordnet sind.

Dabei kann die wenigstens eine Ausnehmung, polygonförmig, insbesondere hexagonal, ausgebildet sein.

Die Ausnehmungen haben dabei zum einen die Funktion, die Anlagefläche und damit Reibkorrosion zu vermindern. Hierdurch wird der Verschleiß vermindert und die Lebensdauer erhöht. Ein weiterer Vorteil ergibt sich in Kombination mit eine Schmierstoff. So kann die wenigstens eine Ausnehmung dazu ausgebildet sein, einen Schmierstoff, insbesondere eine Schmierpaste aufzunehmen. Ein solcher Schmierstoff kann weiter die Reibung und damit Reibkorrosion verringern. Zusätzlich bindet er verschleißbedingten Abrieb, der von dem sich bewegenden Schleifkontakt in die Endlagen und zur Seite geschoben werden kann. Die wenigstens eine Ausnehmung hat somit eine Reinigungswirkung, bei jeder Betätigung wird der Schleifkontakt beim Überfahren der wenigstens einen Ausnehmung gereinigt (Selbstreinigung).

Die wenigstens eine Ausnehmung fungiert dabei als Fettdepot, indem sich der Schmierstoff ebenfalls darin zu sammeln vermag. Metallische Oxide am Schleifkontakt können durch eine sich durch die Vielzahl von Ausnehmungen bildende Struktur aufgebrochen werden, wodurch der Übergangswiderstand zwischen Schleifkontakt und Kontaktabschnitt sich nicht nennenswert erhöht.

In Versuchsreihen haben sich insbesondere viereckig, pentagonal, hexagonal, heptagonal oder oktogonal geformte Ausnehmungen mit einem minimalen Innenwinkel von wenigstens 90 Winkelgrad als besonders günstig herausgestellt.

Die Ausnehmungen können eine maschenartige Struktur erzeugen, wobei die Ausnehmungen von Verbindungsstegen begrenzt werden, welche die verbleibenden Kontaktflächen an den Kontaktsegmenten 14, 16, 18 bilden. Diese weisen eine minimale Erstreckung (Stegbreite) auf.

Die Ausnehmung(en) kann bzw. können insbesondere in einer Orientierung relativ zu der Bewegungsrichtung des Schleifkontakts angeordnet sein, dass, dass keiner der Verbindungsstege parallel zu der Bewegungsrichtung des Schleifkontakts angeordnet ist.

Weiterhin hat sich gezeigt, dass eine Dimensionierung der wenigstens einen Ausnehmung günstig ist, bei der die verbleibenden Kontaktflächen (Verbindungsstege) an den Kontaktsegmenten eine minimale Erstreckung (Stegbreite) von wenigstens 125 µm für eine ausreichend gute Leitfähigkeit aufweisen. Weiterhin hat sich als günstig erwiesen, wenn die Ausnehmungen eine maximale Erstreckung (maximaler Durchmesser) von etwa dem Doppelten der minimalen Erstreckung der verbleibenden Kontaktflächen an den Kontaktsegmenten aufweisen, beispielsweise eine maximale Erstreckung von weniger als 250 µm.

In einer vorteilhaften Ausgestaltung ist eine Vielzahl von polygonalen Ausnehmungen vorgesehen, die ein Vielzahl von vermaschten Verbindungsstegen ausbilden.

Bei einer Stegbreite der Verbindungsstege von wenigstens 125 µm und einer maximalen Erstreckung der Ausnehmungen von 250 µm, bilden die polygonförmigen Ausnehmungen etwa 1/3 des jeweiligen Kontaktsegments, während die Verbindungsstege etwa 2/3 des jeweiligen Kontaktsegments ausmachen. Daraus ergibt sich eine Freistellung für den Schmierstoff von etwa 33% der Kontaktfläche. Durch die Orientierung der Ausnehmungen relativ zu der Bewegungsrichtung des Schleifkonktakts hat der über die Kontaktsegmente mit polygonaler Struktur geführte Schleifkontakt permanent mehrere Kontaktpunkte mit einer Vielzahl der vermaschten Verbindungsstege. So kann ein stabiles elektrisches Signal bereitgestellt werden, trotz der hohen Freistellungsfläche von 33%.

Alternativ oder zusätzlich kann vorgesehen sein, dass der Abstand zwischen den wenigstens zwei Kontaktsegmenten in Richtung der Bewegung des Schleifkontakts eine maximale Erstreckung hat, die kleiner als die Erstreckung des wenigstens einen Gegenkontaktbereichs des Schleifkontakts in Richtung der Bewegung des Schleifkontakts, insbesondere kleiner oder gleich der halben Erstreckung des Gegenkontaktbereichs in Richtung der Bewegung des Schleifkontakts ist. Es entsteht so trotz der mechanischen Freistellen zwischen zwei Kontaktsegmenten kein Einbruch der Ausgangsspannung, weil der Schleifkontakt niemals in einem elektrisch freien Feld liegt.

Alternativ oder zusätzlich kann vorgesehen sein, dass das Betätigungselement einen Schiebeschalter umfasst, der dazu eingerichtet ist, den Schleifkontakt translatorisch relativ zu der Leiterplatte zu bewegen.

Alternativ oder zusätzlich kann vorgesehen sein, dass die Leiterplatte ferner einen Kondensator aufweist, der dazu ausgebildet ist, zusammen mit der Leitfläche als RC-Filter zu wirken.

Wie bereits vorstehend ausgeführt ist bei Lösungen mit mehrere Kontaktsegmenten das Ausgangssignal kaskadiert proportional und somit gestuft. Durch einen simplen RC(Widerstands-Kondensator- bzw. Tiefpass)-Filter kann die Ausgangsspannung nochmals geglättet werden und es entstehen weniger Einbrüche und Spitzen.

Eine Neuerung gemäß dieser Weiterbildung der Erfindung besteht darin, dass die Widerstandskomponente des RC-Filters nicht aus einem herkömmlich bestückbaren Widerstandsbauteil bestehen muss, sondern ebenfalls aus einem kleinen karbonhaltigen Widerstandspunkt bestehen kann, der deutlich kostengünstiger in der Herstellung ist.

Zudem betrifft die Erfindung auch einen elektrischen Schalter zur Anpassung einer Stellgröße einer damit verbundenen Antriebseinheit, beispielsweise zur Einstellung einer Drehzahl der Antriebseinheit einer angetriebenen Werkzeugmaschine mit den Merkmalen nach einem der Ansprüche 1 bis 11. Dieser weist die Merkmale des Anspruchs 12 auf.

Schließlich betrifft die Erfindung auch eine Leiterplatte für einen elektrischen Schalter nach Anspruch 12.

Ergänzend sei darauf hingewiesen, dass Begriffe, wie "umfassend" "aufweisen" oder "mit" keine anderen Merkmale oder Schritte ausschließen. Ferner schließen Begriffe "ein" oder "das", die auf einer Einzahl von Schritten oder Merkmalen hinweisen, keine Mehrzahl von Merkmalen oder Schritten aus und umgekehrt.

Weitere Merkmale und Vorteile der Erfindung ergeben sich aus der nachfolgenden Beschreibung eines Ausführungsbeispiels der Erfindung sowie aus den Unteransprüchen.

Die Erfindung ist nachfolgend unter Bezugnahme auf die beigefügten Figuren näher beschrieben. Die Figuren zeigen mehrere Merkmale der Erfindung in Kombination miteinander. Selbstverständlich vermag der Fachmann diese jedoch auch losgelöst voneinander zu betrachten und gegebenenfalls zu weiteren sinnvollen Unterkombinationen zu kombinieren, ohne dass er hierfür erfinderisch tätig werden müsste.

Es zeigen schematisch:
- Figur 1: eine beispielhafte angetriebene Werkzeugmaschine, die mit einem elektrischen Schalter gemäß der vorliegenden Erfindung ausgestattet sein kann;
- Figur 2: eine Draufsicht auf eine Leiterplatte eines elektrischen Schalters gemäß der vorliegenden Erfindung in einer ersten Ausführungsform; und
- Figur 3: eine Draufsicht auf die Struktur eines Kontaktbereichs einer Leiterplatte eines elektrischen Schalters gemäß der vorliegenden Erfindung in einer zweiten Ausführungsform.

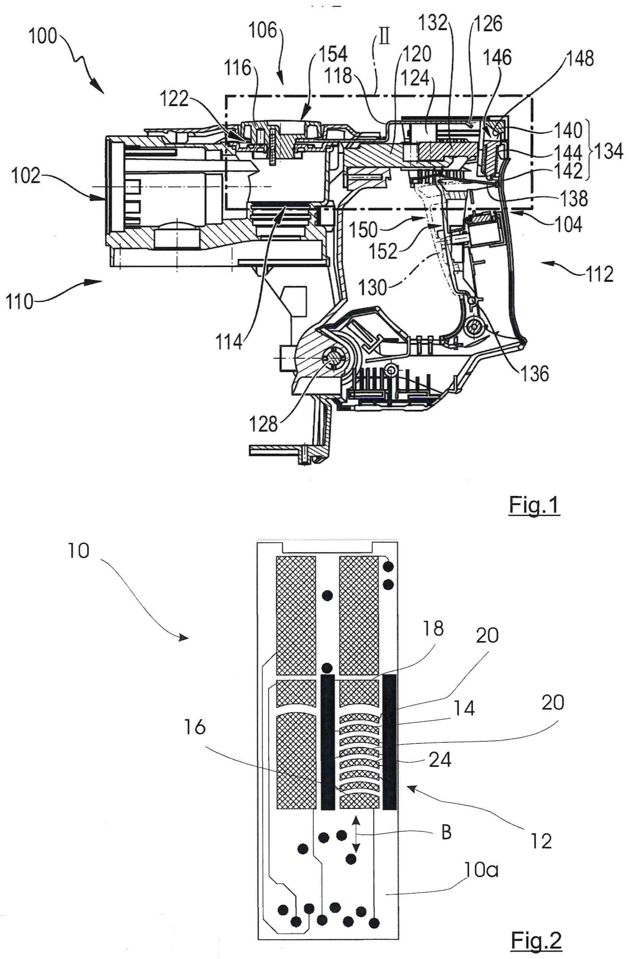

Die Figur 1 zeigt beispielhaft eine angetriebene Werkzeugmaschine, die mit einem elektrischen Schalter gemäß der vorliegenden Erfindung ausgestattet sein kann.

Bei der gezeigten angetriebenen Werkzeugmaschine 100 handelt es sich um eine handgehaltene Werkzeugmaschine, welche einen Hauptkörper 102 und eine Greifeinheit 104 umfasst. Zu Beschreibungszwecken weist die Hand-Werkzeugmaschine 100 eine Oberseite 106, eine Unterseite 108, eine Körperseite 110 sowie eine Greifseite 112 auf, wobei auf der Körperseite 110 der Hauptkörper 102 und auf der Greifseite 112 die Greifeinheit 104 angeordnet ist.

An dem nur teilweise dargestellten Hauptkörper 102 ist ein hier nicht dargestelltes Arbeitswerkzeug befestigbar, zum Beispiel ein Meißel oder Bohrmeißel. Der Hauptkörper 102 umfasst eine Antriebseinrichtung 114 zum Antreiben des Arbeitswerkzeugs, und ein Bedienelement 116 zum Einstellen verschiedener Betriebsmodi (Bohren oder Bohren mit Meißel) der Antriebseinrichtung 114. Die Antriebseinrichtung 114 ist in Fig. 1 in einen ersten Betriebsmodus eingestellt dargestellt.

Zudem umfasst der Hauptkörper 102 ein mittels des Bedienelements 116 bewegbares Blockierelement 118, sowie ein Führungselement 120, auf dessen Oberseite 106 das Blockierelement 118 aufliegt und während seiner Bewegung gleitet bzw. entlang geführt wird, um das - hier als Drehschalter ausgebildeten - Bedienelement 116 zu blockieren.

Die Greifeinheit 104 umfasst einen elektrischen Schalter mit einem Betätigungselement 130, ein Dämpfelement 132 und eine Arretiereinrichtung 134. Das Schaltelement 130 dient zum Ein- und Ausschalten der Antriebseinrichtung 114, und weist eine Drehachse 136 und eine Aussparung 138 auf. Das Dämpfelement 132 umgreift das an dem Hauptkörper 102 angeordnete Führungselement 120, zu welchem das Dämpfelement 132 einen dämpfend wirkenden Bewegungsspielraum aufweist. Gemeinsam mit dem Drehgelenk 128 bilden das Dämpfelement 132 und das Führungselement 120 eine vibrationsgedämpfte Lagerung der Greifeinheit 104 an dem Hauptkörper 102.

Die Arretiereinrichtung 134 umfasst einen Arretierknopf 140, einen Arretierhaken 142 und eine hier als Schraubendruckfeder ausgebildete Arretierfeder 144, um das Betätigungselement 130 für mehr Anwendungskomfort in seiner spezifischen Stellung zu arretieren. Dabei weist der Arretierknopf 140 einen Eingriff 146 auf, welcher an seiner Oberseite 106 von einer schrägen Wandung des Arretierknopfes 140 begrenzt ist. Auf dieser der Körperseite 110 und der Unterseite 108 zugewandt ausgerichteten Wandung ist eine zweite Anlagefläche 148 ausgebildet.

Wie bereits erwähnt, dient das Betätigungselements 130 zum Ein- und Ausschalten der Antriebseinrichtung 114. Zu diesem Zweck ist das Betätigungselement 130 in der beispielhaften Ausgestaltung mittels der Drehachse 136 schwenkbar mit der Greifeinheit 104 verbunden. Für das Einschalten ist das Betätigungselement 130 mittels Drückens in Richtung der Greifseite 112 und gegen eine Rückstellkraft einer hier nicht dargestellten Druckfeder von einer Ausschaltposition 150 in eine Einschaltposition 152 überführbar. Für das Ausschalten ist das Betätigungselement 130 mittels Loslassen eigenständig bzw. mithilfe der Rückstellkraft von der Einschaltposition 152 in die Ausschaltposition 150 zurückführbar.

Weiterhin kann je nach Stellung des Betätigungselements 130 die Drehgeschwindigkeit der Antriebseinrichtung 114 variiert werden. So kann beispielsweise in einer voll durchgedrückten Stellung die maximale Drehzahl der Antriebseinrichtung eingestellt werden, während in einer leicht gedrückten Stellung des Betätigungselements 130 die Drehgeschwindigkeit der Antriebseinrichtung 114 gering ist und in gelöster bzw. ungedrückter Stellung (Ausschaltposition 150) minimal d.h. gleich Null ist.

Die Einstellung der Drehgeschwindigkeit erfolgt über eine erfindungsgemäße Ausgestaltung des Betätigungselements 130 des elektrischen Schalters, wie folgt.

Der elektrische Schalter umfasst das Betätigungselement 130, einen mit dem Betätigungselement 130 verbundenen Schleifkontakt (nicht dargestellt) sowie eine Leiterplatte 10 (vgl. Figur 2). An der Leiterplatte 10 ist erfindungsgemäß wenigstens ein Kontaktbereich 12 ausgebildet, der von dem Schleifkontakt mit wenigstens einem Gegenkontaktbereich elektrisch kontaktiert werden kann. Dabei überfährt der Schleifkontakt bei der Schaltbewegung des Betätigungselements 130 mit seinem Gegenkontaktbereich in einer Bewegungsrichtung B den Kontaktbereich 12 der Leiterplatte 10, so dass je nach Stellung des Schleifkontakts relativ zu dem Kontaktbereich 12 ein prozentualer Abgriff der Betriebsspannung erfolgt. Entsprechend der abgegriffenen Betriebsspannung wird wiederum die Drehzahl der Antriebseinrichtung 114 eingestellt.

Erfindungsgemäß ist vorgesehen, dass der Kontaktbereich 12 wenigstens zwei Kontaktsegmente 14, 16, 18 (in der gezeigten Ausführungsform der Figur 2 ist es eine Vielzahl von Kontaktsegmenten 14 sowie endseitig ein Kontaktsegment 16 und ein Kontaktsegment 18) aufweist. Diese weisen einen metallischen Werkstoff auf oder sind zumindest teilweise aus einem metallischen Werkstoff, wie beispielsweise Kupfer ausgebildet. Die Kontaktsegmente können beispielsweise als Einlegeteile ausgebildet sein, die in die Leiterplatte 10 eingelegt sind.

Weiterhin erkennt man an der Figur 2, dass die Kontaktsegmente 14, 16, 18 beabstandet zueinander angeordnet sind. Dabei kann der Abstand zwischen zwei benachbarten Kontaktsegmenten 14, 16, 18 derart gewählt sein, dass dieser in Richtung der Bewegung B des Schleifkontakts eine maximale Erstreckung hat, die kleiner als die Erstreckung des wenigstens einen Gegenkontaktbereichs des Schleifkontakts in Richtung der Bewegung B des Schleifkontakts, insbesondere kleiner oder gleich der halben Erstreckung des Gegenkontaktbereichs in Richtung der Bewegung B des Schleifkontakts ist. Es entsteht so trotz der mechanischen Freistellen zwischen zwei benachbarten Kontaktsegmenten 14, 16, 18 kein Einbruch der Ausgangsspannung, weil der Schleifkontakt niemals in einem elektrisch freien Feld liegt.

Die gezeigten Kontaktsegmente 14 der Figur 2 sind weiterhin als sichelförmig oder ringbogenförmig - in einer Draufsicht auf die Leiterplatte 10 betrachtet - ausgebildet. Die beiden endseitigen Kontaktsegmente 16, und 18 haben benachbart zu den Kontaktsegmenten 14 ebenfalls eine konvexe (Kontaktsegment 16) bzw. konkave (Kontaktsegment 18) Kontur. Die Krümmungsradien der gekrümmten Konturabschnitte der sichelförmig oder ringbogenförmig ausgebildeten Kontaktsegmente 14 bzw. der Kontaktsegmente 16 und 18 können so ausgestaltet und angeordnet sein, dass die wenigstens eine Gegenkontaktfläche des Schleifers, insbesondere wenn diese ebenfalls abgerundete Kanten aufweist, mit einem oder mehreren gegenläufigen Radien an die Kontaktsegmente 14, 16, 18 angelegt werden können, um den Verschleiß weiter zu vermindern.

Die Kontaktsegmente 14 sind in einem sich wiederholenden Muster parallel zueinander an oder auf der Leiterplatte angeordnet.

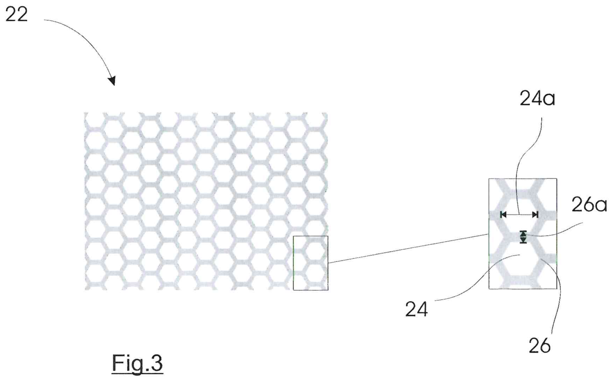

Weiterhin weisen die Kontaktsegmente 14, 16, 18 wenigstens eine Ausnehmung 24 (vgl. Figuren 2 und 3), in der gezeigten Ausführungsform eine Vielzahl von Ausnehmungen, auf, die in einem sich wiederholenden Muster an dem Kontaktsegment angeordnet sind und so eine Struktur des Kontaktsegments bilden.

In der gezeigten Ausführungsform der Figur 2 sind diese viereckig (quadratisch) ausgebildet, während die Ausnehmungen in der alternativen Ausführungsform der Figur 3 hexagonal, ausgebildet ist.

Die Ausnehmungen 24 haben dabei zum einen die Funktion, die Anlagefläche der Kontaktsegmente an den Schleifkontakt und damit Reibkorrosion zu vermindern. Hierdurch wird der Verschleiß vermindert und die Lebensdauer erhöht.

Eine weitere Funktion besteht darin, einen Schmierstoff, insbesondere eine Schmierpaste aufzunehmen. Ein solcher Schmierstoff kann weiter die Reibung und damit Reibkorrosion verringern. Zusätzlich bindet er verschleißbedingten Abrieb, der von dem sich bewegenden Schleifkontakt in die Endlagen und zur Seite geschoben werden kann. Die wenigstens eine Ausnehmung 24 hat somit eine Reinigungswirkung, bei jeder Betätigung wird der Schleifkontakt beim Überfahren der wenigstens einen Ausnehmung gereinigt (Selbstreinigung).

Die wenigstens eine Ausnehmung 24 fungiert dabei als Fettdepot, indem sich der Schmierstoff ebenfalls darin zu sammeln vermag. Metallische Oxide am Schleifkontakt können durch eine sich durch die Vielzahl von Ausnehmungen bildende Struktur aufgebrochen werden, wodurch der Übergangswiderstand zwischen Schleifkontakt und Kontaktabschnitt sich nicht nennenswert erhöht.

In Versuchsreihen haben sich insbesondere viereckig, pentagonal, hexagonal, heptagonal oder oktogonal geformte Ausnehmungen 24 mit einem minimalen Innenwinkel von wenigstens 90 Winkelgrad als besonders günstig herausgestellt.

Die Ausnehmungen 24 erzeugen eine maschenartige Struktur, wobei die Ausnehmungen 24 durch Verbindungsstege 26 begrenzt werden. Die Verbindungsstege 26 sind dabei durch die verbleibenden Kontaktflächen an den Kontaktsegmenten 14, 16, 18 ausgebildet und haben eine minimale Erstreckung 26a (Stegbreite).

Die Ausnehmung(en) 24 sind in den gezeigten Ausführungsformen der Figuren 2 und 3 derart relativ zu der Bewegungsrichtung B des Schleifkontakts angeordnet sein, dass keiner der Verbindungsstege 26 parallel zu der Bewegungsrichtung B des Schleifkontakts angeordnet ist.

Bei den Ausnehmungen 24 der Figur 3 kann der maximale Durchmesser 24a der Ausnehmung 24 kleiner oder gleich 500µm, insbesondere kleiner oder gleich 300µm, beispielsweise kleiner oder gleich 250µm sein. Weiterhin kann die Stegbreite 26a der Verbindungsstege 26 größer oder gleich 50µm, insbesondere größer oder gleich 100µm, beispielsweise größer oder gleich 125µm für eine ausreichend gute Leitfähigkeit sein.

In einer vorteilhaften Ausgestaltung ist eine Vielzahl von polygonalen Ausnehmungen vorgesehen, die ein Vielzahl von vermaschten Verbindungsstegen ausbilden.

Bei einer Stegbreite 26a der Verbindungsstege 26 von 125 µm bilden die polygonförmigen Ausnehmungen 24 der Figur 2 etwa 1/3 des jeweiligen Kontaktsegments 14, 16, 18, während die Verbindungsstege etwa 2/3 des jeweiligen Kontaktsegments 14, 16, 18 ausmachen. Daraus ergibt sich eine Freistellung für den Schmierstoff von 33% der Kontaktfläche. Durch die Orientierung der Ausnehmungen 24 relativ zu der Bewegungsrichtung B des Schleifkontakts hat der über die Kontaktsegmente 14, 16, 18 mit polygonaler Struktur geführte Schleifkontakt permanent mehrere Kontaktpunkte mit einer Vielzahl der vermaschten Verbindungsstege 26. So entsteht ein stabiles elektrisches Signal, trotz der hohen Freistellungsfläche von 33%.

In der Figur 2 ist zu erkennen, dass neben dem Kontaktbereich 12 der Leiterplatte wenigstens eine, in der gezeigten Ausführungsform zwei Leitflächen 20 ausgebildet sind, die entlang dem Kontaktbereich 12 verlaufen. Die Leitflächen 20 umfassen einen karbonhaltigen Werkstoff und dienen der elektrischen Verbindung der einzelnen (kaskadierten) Kontaktsegmente 14, 16, 18.

Auf diese Weise kann eine Lösung bereitgestellt werden, die ohne externe Festwiderstände eine langlebige und kostensparende Ausgestaltung eines elektrischen Schalters ermöglicht.

Dabei kann die wenigstens eine Leitfläche 20 eine auf die Leiterplatte 10 aufgebrachte, insbesondere aufgedruckte, Karbonschicht umfassen. Die Leitflächen 20 können beispielsweise aus weicher, leitfähiger Karbonpaste mit einem hartem nicht-leitenden Epoxyharz bestehen. Anders als im Stand der Technik werden die Leitflächen 20 nicht von dem Schleifkontakt überfahren und somit entfällt das bekannte Problem einer Reibkorrosion, wodurch stellenweise die weichen Karbonpartikel ausgetragen werden können. Zugleich stellen die Leitflächen 20 eine besonders einfache und kostengünstige Lösung dar, um zwei oder mehr Kontaktsegmente 14, 16, 18 des Kontaktbereichs elektrisch miteinander zu verbinden.

Die empfindlichen karbonhaltigen Leitfläche 20 dienen somit als elektrisches Widerstandsmaterial, unterliegt jedoch keinem Verschleiß mehr, wodurch die Lebensdauer gegenüber bekannten Lösungen erhöht werden kann.

## Patentansprüche

1. Angetriebene Werkzeugmaschine (100) mit einer Antriebseinheit (114) und einem elektrischen Schalter zur Anpassung einer Stellgröße der Antriebseinheit (114), beispielsweise zur Einstellung einer Drehzahl der Antriebseinheit (114), aufweisend:
eine Leiterplatte (10) mit wenigstens einem Kontaktbereich (12),
wenigstens ein Betätigungselement (130) zur manuellen Betätigung durch einen Anwender, und
einen mit dem Betätigungselement (130) verbundenen Schleifkontakt, der wenigstens einen Gegenkontaktbereich aufweist, welcher dazu ausgebildet ist, infolge einer manuellen Betätigung des Betätigungselements (130) durch den Anwender in schleifendem Kontakt über den Kontaktbereich (12) der Leiterplatte (10) bewegt zu werden,
wobei der Schleifkontakt wenigstens im Gegenkontaktbereich zur Kontaktierung des Kontaktbereichs (12) wenigstens abschnittsweise aus einem metallischen Werkstoff ausgebildet ist,
wobei der Kontaktbereich (12) wenigstens zwei Kontaktsegmente (14, 16, 18) aufweist, die beabstandet zueinander an oder auf der Leiterplatte (10) angeordnet sind und jeweils eine Kontaktfläche mit einem metallischen Werkstoff aufweisen,
wobei die Leiterplatte (10) in wenigstens einem zu dem Kontaktbereich (12) benachbarten Bereich wenigstens eine Leitfläche (20) zur elektrischen Verbindung der wenigstens zwei Kontaktsegmente (14, 16, 18) miteinander aufweist, und
wobei die wenigstens eine Leitfläche (20) einen karbonhaltigen Werkstoff umfasst.

2. Angetriebene Werkzeugmaschine (100) nach Anspruch 1,
wobei wenigstens eines der wenigstens zwei Kontaktsegmente (14, 16, 18) ein Einlegeteil mit einem kupferhaltigen Werkstoff umfasst und in die Leiterplatte (10) eingelegt ist.

3. Angetriebene Werkzeugmaschine (100) nach Anspruch 1 oder 2,
wobei die wenigstens eine Leitfläche (20) eine auf die Leiterplatte (10) aufgebrachte, insbesondere aufgedruckte, Karbonschicht umfasst.

4. Angetriebene Werkzeugmaschine (100) nach einem der vorhergehenden Ansprüche, wobei die wenigstens zwei Kontaktsegmente (14, 16, 18) und die wenigstens eine Leitfläche (20) auf derselben Seite (10a) der Leiterplatte (10) angeordnet sind.

5. Angetriebene Werkzeugmaschine (100) nach einem der vorhergehenden Ansprüche, wobei die Kontaktsegmente (14, 16, 18) sichelförmig oder ringbogenförmig ausgebildet sind oder in einer Draufsicht auf die Leiterplatte (10) betrachtet zumindest eine Krümmungskontur aufweisen.

6. Angetriebene Werkzeugmaschine (100) nach einem der vorhergehenden Ansprüche, wobei die wenigstens zwei Kontaktsegmente (14, 16, 18) in einem sich wiederholenden Muster parallel zueinander an oder auf der Leiterplatte (10) angeordnet sind.

7. Angetriebene Werkzeugmaschine (100) nach einem der vorhergehenden Ansprüche, wobei wenigstens eines der wenigstens zwei Kontaktsegmente (14, 16, 18) wenigstens eine Ausnehmung (24), insbesondere eine Vielzahl von Ausnehmungen (24), aufweist, die in einem sich wiederholenden Muster und/oder in einer Struktur an dem Kontaktsegment (14, 16, 18) angeordnet sind.

8. Angetriebene Werkzeugmaschine (100) nach Anspruch 7,
wobei die wenigstens eine Ausnehmung (24), polygonförmig, insbesondere quadratisch, pentagonal, hexagonal, heptagonal oder oktogonal, ausgebildet ist.

9. Angetriebene Werkzeugmaschine (100) nach Anspruch 7 oder 8,
wobei die wenigstens eine Ausnehmung (24) dazu ausgebildet ist, einen Schmierstoff, insbesondere eine Schmierpaste aufzunehmen.

10. Angetriebene Werkzeugmaschine (100) nach einem der vorhergehenden Ansprüche, wobei der Abstand zwischen den wenigstens zwei Kontaktsegmenten (14, 16, 18) in Richtung der Bewegung (B) des Schleifkontakts eine maximale Erstreckung hat, die kleiner als die Erstreckung des wenigstens einen Gegenkontaktbereichs des Schleifkontakts in Richtung der Bewegung (B) des Schleifkontakts, insbesondere kleiner oder gleich der halben Erstreckung des Gegenkontaktbereichs in Richtung der Bewegung (B) des Schleifkontakts ist.

11. Angetriebene Werkzeugmaschine (100) nach einem der vorhergehenden Ansprüche, wobei das Betätigungselement (130) einen Schiebeschalter umfasst, der dazu eingerichtet ist, den Schleifkontakt translatorisch relativ zu der Leiterplatte (10) zu bewegen.

12. Angetriebene Werkzeugmaschine (100) nach einem der vorhergehenden Ansprüche, wobei die Leiterplatte (10) ferner einen Kondensator aufweist, der dazu ausgebildet ist, zusammen mit der Leitfläche (20) als RC-Filter zu wirken.

13. Elektrischer Schalter zur Anpassung einer Stellgröße einer damit verbundenen Antriebseinheit (114), beispielsweise zur Einstellung einer Drehzahl der Antriebseinheit (114) einer angetriebenen Werkzeugmaschine (100) nach einem der Ansprüche 1 bis 11, aufweisend:
eine Leiterplatte (10) mit wenigstens einem Kontaktbereich (12),
wenigstens ein Betätigungselement (130) zur manuellen Betätigung durch einen Anwender, und
einen mit dem Betätigungselement (130) verbundenen Schleifkontakt, der wenigstens einen Gegenkontaktbereich aufweist, welcher dazu ausgebildet ist, infolge einer manuellen Betätigung des Betätigungselements (130) durch den Anwender in schleifendem Kontakt über den Kontaktbereich (12) der Leiterplatte (10) bewegt zu werden,
wobei der Schleifkontakt wenigstens im Gegenkontaktbereich zur Kontaktierung des Kontaktbereichs (12) wenigstens abschnittsweise aus einem metallischen Werkstoff ausgebildet ist,
wobei der Kontaktbereich (12) wenigstens zwei Kontaktsegmente (14, 16, 18) aufweist, die beabstandet zueinander an oder auf der Leiterplatte (10) angeordnet sind und jeweils eine Kontaktfläche mit einem metallischen Werkstoff aufweisen,
wobei die Leiterplatte (10) in wenigstens einem zu dem Kontaktbereich (12) benachbarten Bereich wenigstens eine Leitfläche (20) zur elektrischen Verbindung der wenigstens zwei Kontaktsegmente (14, 16, 18) miteinander aufweist, und
wobei die wenigstens eine Leitfläche (20) wenigstens eine einen karbonhaltigen Werkstoff umfasst.

14. Leiterplatte (10) für einen elektrischen Schalter nach Anspruch 12.
